# EUROPÄISCHE PATENTSCHRIFT

(11) **EP 0 406 600 B1**
(45) Veröffentlichungstag und Bekanntmachung des Hinweises auf die Patenterteilung: **01.06.1994**
(21) Anmeldenummer: 90111292.0
(22) Anmeldetag: 15.06.1990
(51) Int. Cl.: G03F 7/016, G03F 7/008, C08L 75/16, C08L 51/08, C08F 283/00

(54) **Lichthärtbares Gemisch und daraus hergestelltes lichthärtbares Aufzeichnungsmaterial**
Photocurable composition and photocurable recording material made therefrom
Composition photodurcissable et matériau d'enregistrement photodurcissable produit de cela

(30) Priorität: 21.06.1989 DE 3920230
(43) Veröffentlichungstag der Anmeldung: 09.01.1991
(73) Patentinhaber: HOECHST AKTIENGESELLSCHAFT, 65926 Frankfurt am Main (DE)
(72) Erfinder: Müller-Hess, Waltraud, Dr., D-6200 Wiesbaden (DE); Mohr, Dieter, Dr., D-6501 Budenheim (DE); Kroggel, Matthias, Dr., D-6233 Kelkheim (DE); Rauterkus, Karl-Josef, Dr., D-6233 Kelkheim (DE)

(56) Entgegenhaltungen:
- DE-A- 2 739 774
- DE-A- 3 036 077
- DE-A- 3 404 366
- DE-A- 3 732 089
- DE-A- 3 835 840
- DERWENT ACCESSION NO. 87-339 611, Questel Telesystems (WPIL), Derwent Publications Ltd., London, GB

## Beschreibung

Die Erfindung betrifft ein lichthärtbares Gemisch, das ein Diazoniumsalz-Polykondensationsprodukt oder eine organische Azidoverbindung als lichtempfindliche Verbindung und ein polymeres Bindemittel enthält und das insbesondere zur Herstellung von Druckplatten und Photoresists geeignet ist.

Aus der DE-A 20 24 244 (= US-A 3 867 147) ist es bekannt, lichtempfindliche Aufzeichnungsmaterialien aus Mischkondensationsprodukten von kondensationsfähigen Diazoniumsalzen und anderen nicht lichtempfindlichen kondensationsfähigen Verbindungen, gegebenenfalls in Kombination mit polymeren Bindemitteln, zur Herstellung von Druckplatten zu verwenden. Diese lichtempfindlichen Materialien zeichnen sich durch hohe Lichtempfindlichkeit und gute Druckauflagen aus. Die Auflage ist besonders hoch bei Verwendung von wasserunlöslichen Bindemitteln, z. B. Polyvinylformal, doch lassen sich solche Schichten nur mit solchen Entwicklern sauber verarbeiten, die einen erheblichen Anteil an flüchtigen organischen Lösemitteln enthalten. Aus ökologischen Gründen ist man bestrebt, auch die Entwicklung von Druckplatten dieses Typs mit rein wäßrigen Lösungen zu erreichen. Im günstigsten Fall können solche Platten mit relativ aggressiven sauren oder alkalischen rein wäßrigen Lösungen entwickelt werden, indem die Nichtbildbereiche der Schicht in Form von Fladen oder kleineren Partikeln im Entwickler suspendiert werden. Dabei besteht die Gefahr, daß sich solche Partikel unkontrolliert an Nichtbildstellen der Platte redeponieren und diese unbrauchbar machen.

Aus der DE-A 31 30 987 sind ähnliche Gemische bekannt, die als Bindemittel Styrol-Maleinsäureanhydrid-Mischpolymerisate enthalten und die sich mit rein wäßrigen alkalischen Lösungen entwickeln lassen. Die mit diesen Gemischen erhaltenen Druckplatten liefern jedoch geringere Druckauflagen als solche, die in wäßrigem Alkali unlösliche Bindemittel enthalten.

Aus der DE-A 30 36 077 (= US-A 4 387 151) sind ferner entsprechende Gemische bekannt, die als Bindemittel Polymere mit seitenständigen Alkenylsulfonylurethangruppen enthalten. Auch diese Gemische lassen sich mit rein wäßrigen alkalischen Lösungen entwickeln. Bei der Verarbeitung zu Flachdruckplatten ergeben sie jedoch lichtgehärtete Schichten, deren Farbannahme nicht zufriedenstellend ist.

In der DE-A 24 29 251 wird ein Gemisch beschrieben, das eine lichtempfindliche Diazoverbindung und ein Bindemittel enthält, das durch Umsetzen eines Hydroxyl- oder Carboxylgruppen enthaltenden Polymeren mit einem Vernetzungsmittel erhalten wird, das Isocyanat-, Epoxid- oder Säureanhydridgruppen enthält. Durch die Vernetzung wird die Löslichkeit des Polymeren herabgesetzt. Soweit dadurch Produkte mit hoher Druckauflage erreicht werden, ist zur Entwicklung der Zusatz organischer Lösemittel erforderlich. Weniger vernetzte Produkte enthalten häufig noch unumgesetzte Vernetzungsgruppen und haben deshalb nur eine begrenzte Lagerfähigkeit.

Aus der EP-A 152 819 sind lichtempfindliche Gemische aus Diazoniumsalz-Polykondensationsprodukten und Carboxylgruppen enthaltenden Bindemitteln bekannt, die durch Umsetzen von Hydroxylgruppen enthaltenden Polymeren mit Säureanhydriden erhalten worden sind. Diese Gemische lassen sich mit wäßrig-alkalischen Lösungen entwickeln und sind zur Herstellung von Flachdruckformen hoher Auflagenleistung geeignet. Eine weitere Auflagensteigerung dieser Gemische ist jedoch erwünscht. Es wird deshalb in dieser Druckschrift empfohlen, andere Polymere, z. B. Polyurethane, zur Erhöhung der Abriebbeständigkeit in kleinerer Menge zuzusetzen. Diese Kombination führt jedoch zu kopiertechnischen Nachteilen, z. B. zu einer unerwünschten Tonwertzunahme. Auch wird dadurch die Entwickelbarkeit und die Lagerstabilität beeinträchtigt. Diese Gemische haben außerdem - ebenso wie andere Gemische mit Carboxylgruppen enthaltenden Bindemitteln - den Nachteil, daß sie bei der Verarbeitung mit Entwicklern auf Basis von Leitungswasser zur Ausfällung schwerlöslicher Calciumsalze neigen, die sich in den Entwicklungsmaschinen absetzen und zu Störungen führen.

Schließlich sind aus der US-A 3 660 097 und der DE-A 27 39 774 Gemische der angegebenen Gattung bekannt, in denen Polyurethane als polymere Bindemittel Verwendung finden. Der Nachteil dieser Gemische besteht darin, daß die Bindemittel in den üblichen Beschichtungslösungsmitteln schlecht löslich sind und die Lösungen zur Entfernung von unlöslichen Rückständen mehrfach filtriert werden müssen. Die wäßrig-alkalische Entwickelbarkeit dieser Gemische ist sehr begrenzt und die erzielbare Druckauflage für einen Hochleistungsbereich nicht ausreichend.

Aus der EP-A 0 030 001 ist ein ähnliches Gemisch bekannt, welches als Bindemittel ein verzweigtes Polyurethan enthält. Obwohl mit Hilfe dieses Gemisches relativ hohe Druckauflagen erreichbar sind, weist es ebenfalls einige Nachteile auf. Beispielsweise sind für eine schleierfreie, zügige Entwicklung der lichtgehärteten Schicht bevorzugt saure wäßrige Entwicklerlösungen zu verwenden, die noch organische Lösemittel enthalten. Diese Entwickler können außerdem bei maschineller Verarbeitung zu Korrosionsproblemen der Leichtmetallteile der Entwicklermaschinen führen.

In der DE-A 37 32 089 werden Pfropfpolymerisate beschrieben, die aus einem Polyurethan als Pfropfgrundlage und aufgepfropften Vinylestereinheiten bestehen, die mindestens teilweise zu Vinylalkoholeinheiten verseift sind. Die Polymeren werden als Bindemittel für Pigmente, zur Herstellung von Druckfarben, von Schmelzklebern, von lösemittelhaltigen Klebstoffen, als Bestandteil von Lacken oder Beschichtungsmitteln für Fasern, Folien und Metalle und für thermoplastische Formkörper eingesetzt.

In der JP-A 246047/87 werden photopolymerisierbare Gemische beschrieben, die als Bindemittel Pfropfmischpolymerisate aus Polyurethanen und Polyvinylalkohol mit Mercaptogruppen enthalten.

In der älteren deutschen Patentanmeldung P 38 35 840.9 werden Pfropfpolymerisate beschrieben, die aus den vorstehend genannten Pfropfpolymerisaten durch Acetalisieren mit Aldehyden erhalten wurden.

In der älteren deutschen Patentanmeldung P 38 24 146.3 werden lichthärtbare elastomere Gemische beschrieben, die eine radikalisch polymerisierbare Verbindung, einen Photoinitiator und als Bindemittel ein in Wasser oder einer wäßrigen Lösung lösliches oder dispergierbares Pfropfpolymerisat gemäß der DE-A 37 32 089 enthalten.

Aufgabe der Erfindung war es, ein negativ arbeitendes lichtempfindliches Gemisch vorzuschlagen, das für die Herstellung von Druckplatten, insbesondere Flachdruckplatten, geeignet ist, das alle Vorzüge der bekannten Gemische auf Basis von Diazoniumsalz-Polykondensationsprodukten oder Azidoverbindungen aufweist, das sich mit praktisch lösemittelfreien neutralen oder alkalischen wäßrigen Lösungen entwickeln läßt, ohne bei der Verarbeitung mit Leitungswasser enthaltenden Entwicklerlösungen störende Abscheidungen zu ergeben, und das zugleich Druckplatten mit hoher Auflage und guter Farbannahme sowie mit hoher Lagerfähigkeit ergibt, wie sie bisher nur mit solchen Druckplatten erreichbar waren, die zur Entwicklung den Zusatz von größeren Mengen organischer Lösemittel erforderten.

Erfindungsgemäß wird ein lichthärtbares Gemisch vorgeschlagen, das als lichtempfindliche Verbindung ein Diazoniumsalz-Polykondensationsprodukt oder eine organische Azidoverbindung und als Bindemittel ein hochmolekulares Polymeres enthält, das Vinylalkoholeinheiten aufweist.

Das erfindungsgemäße Gemisch ist dadurch gekennzeichnet, daß das Polymere ein Pfropfmischpolymerisat mit einem Polyurethan als Pfropfgrundlage und aufgepfropften Ketten ist, die Vinylalkoholeinheiten enthalten.

Erfindungsgemäß wird ferner ein lichthärtbares Aufzeichnungsmaterial aus einem Schichtträger und einer lichtempfindlichen Schicht vorgeschlagen, das dadurch gekennzeichnet ist, daß die lichtempfindliche Schicht aus dem vorstehend definierten Gemisch besteht.

Die in dem erfindungsgemäßen Gemisch enthaltenen Pfropfmischpolymerisate sind als solche in der DE-A 37 32 089 und der älteren deutschen Patentanmeldung P 38 35 840.9 beschrieben. Zu ihrer Herstellung wird auf eine Pfropfgrundlage aus einem Polyurethan ein Carbonsäurevinylester und ggf. eine weitere damit copolymerisierbare ethylenisch ungesättigte Verbindung aufgepfropft und danach ganz oder teilweise verseift. Die dabei erhaltenen Polymeren mit Vinylalkoholeinheiten können weiter mit Aldehyden zu Polyvinylacetalen umgesetzt werden.

Der Mengenanteil der aufgepfropften Komponenten beträgt im allgemeinen 10 bis 95, vorzugsweise 30 bis 90 und insbesondere 40 bis 80 Gew.-%, bezogen auf das gesamte Pfropfpolymerisat.

Die Pfropfgrundlagen bestehen aus Polyurethanen mit mindestens zwei Urethangruppen im Molekül, wobei die Anzahl der Urethangruppen pro Molekül nach oben keiner besonderen Begrenzung unterliegt und im allgemeinen höhere Werte als 2 hat.

Die als Pfropfgrundlage eingesetzten Polyurethane lassen sich nach üblichen Verfahren der Polyurethansynthese aus Diolen und Diisocyanaten herstellen. Prinzipiell sind alle bei der Polyurethansynthese üblicherweise verwendeten Diole einsetzbar. Bevorzugt werden cycloaliphatische Diole, wie Cyclohexandiole, sowie insbesondere aliphatische Diole mit 2 bis 12 C-Atomen. Bevorzugt werden ferner Polyetherdiole, z. B. Polypropylenoxide, Polybutylenoxide, Mischpolymere aus Ethylenoxid, Propylenoxid, Butylenoxid, vorzugsweise deren Blockcopolymere; besonders bevorzugt werden Polyethylenoxide, insbesondere solche mit Molekulargewichten zwischen 200 und 10 000, insbesondere zwischen 400 und 1500. Die Polyetherdiole werden mit Vorteil in Kombination mit niedermolekularen aliphatischen Diolen, z. B. 1,4-Butandiol, 1,3-Propandiol, Ethylenglykol, Diethylenglykol, 1,2-Hexandiol, 1,2-Propandiol, Pentandiol oder Cyclohexandiol eingesetzt. Bevorzugt liegt ein molares Verhältnis von Polyetherdiol zu niedermolekularem aliphatischem Diol von 1 : 0,1 bis 1 : 0,7 vor.

Als Diisocyanatkomponenten können aromatische Diisocyanate eingesetzt werden. Bevorzugt werden aliphatische und/oder cycloaliphatische Diisocyanate. Bevorzugte aliphatische Diisocyanate sind solche mit 2 bis 12 C-Atomen im aliphatischen Rest, z. B. Ethylendiisocyanat, Propylendiisocyanat, Tetramethylendiisocyanat, 2,2,4-Trimethyl-hexamethylendiisocyanat. Bevorzugte cycloaliphatische Diisocyanate sind z. B. 1,4-Diisocyanato-cyclohexan, Dicyclohexylmethan-4,4′-diisocyanat und Isophorondiisocyanat. Besonders bevorzugt werden Hexamethylendiisocyanat und Isophorondiisocyanat.

Das Molverhältnis von Diol- zu Diisocyanatkomponente liegt vorzugsweise zwischen 1 : 0,99 und 1 : 0,5, insbesondere zwischen 1 : 0,98 und 1 : 0,7. Die mittleren Molekulargewichte der Polyurethane liegen vorzugsweise zwischen 200 und 100 000, insbesondere zwischen 1 000 und 50 000, besonders bevorzugt zwischen 3 000 und 25 000.

Zum Pfropfen auf das Polyurethan werden Carbonsäurevinylester mit 3 bis 20, vorzugsweise 4 bis 14 C-Atomen eingesetzt. Besonders bevorzugt werden Vinylacetat und/oder Vinylpropionat, insbesondere Vinylacetat. Bevorzugt werden ferner Gemische aus Vinylacetat und/oder Vinylpropionat und Vinylversatat. Insbesondere bei Teil- oder Vollverseifung der Produkte im Anschluß an die Pfropfpolymerisation ist beim Pfropfen die Mitverwendung von Vinylpropionat neben Vinylacetat vorteilhaft. Außerdem lassen sich copolymerisierbare Gemische aus Vinylcarbonsäureestern pfropfen, vorzugsweise Gemische aus Vinylacetat und kleineren Mengen Vinylversatat.

Auch das Pfropfen mit verschiedenen Carbonsäurevinylestern in Form von Blockcopolymeren, gegebenenfalls in Kombination mit weiteren ethylenisch ungesättigten und copolymerisationsfähigen Monomeren, kann vorteilhaft sein. Weiterhin können die Carbonsäurevinylester auch zusammen mit anderen ethylenisch ungesättigten und copolymerisierbaren Monomeren, wie Maleinsäure, Itaconsäure, Mesaconsäure, Crotonsäure, Acrylsäure oder deren Estern, gepfropft werden.

Die erhaltenen Pfropfpolymerisate lassen sich durch Hydrolyse, Alkoholyse oder Umesterung in teil- oder vollverseifte Produkte überführen, wobei der Hydrolysegrad mindestens 1 mol-%, vorzugsweise 45 bis 99 mol-%, bezogen auf die Molzahl verseifbarer Monomereinheiten im Pfropfpolymerisat, beträgt. Die Herstellung der Pfropfpolymerisate mit Polyurethan-Pfropfgrundlage ist in der DE-A 37 32 089 beschrieben.

Die verseiften Pfropfpolymerisate lassen sich im sauren Medium nach bekannten Methoden acetalisieren.

Zur Acetalisierung werden aliphatische C₁- bis C₂₀-Aldehyde, die substituiert sein können, und aromatische Aldehyde, die ebenfalls substituiert sein können, eingesetzt. Bevorzugt werden aliphatische Aldehyde mit 1-5 C-Atomen, z. B. n-Butyraldehyd, Isobutyraldehyd, Propionaldehyd oder Formaldehyd. Ggf. substituierte Benzaldehyde, z. B. Benzaldehyd, p-Chlorbenzaldehyd oder p-Methoxy-benzaldehyd, sind ebenfalls geeignet. Es können auch Kombinationen dieser Aldehyde untereinander verwendet werden.

Der Acetalisierungsgrad der erfindungsgemäß als Bindemittel eingesetzten Pfropfpolyvinylacetale liegt vorzugsweise in einem solchen Bereich, daß der Gehalt an nicht acetalisierten Polyvinylalkoholeinheiten in den Pfropfpolyvinylacetalen bevorzugt größer als 15 mol-%, insbesondere 18 bis 60 mol-% und ganz besonders bevorzugt 20 bis 45 mol-%, beträgt, jeweils bezogen auf die molare Menge an Vinylalkoholeinheiten in den eingesetzten verseiften Pfropfpolymerisaten, wobei bis zu 55 mol-%, bezogen auf die ursprüngliche Menge, noch als Vinylestereinheiten vorliegen können. Die Hydroxylzahl des fertigen Bindemittels sollte im Bereich von 100 bis 800 liegen.

Die Acetalisierung kann nach zwei Verfahren erfolgen:
Bei der ersten Ausführungsform wird das Pfropfpolymere in einem Alkohol oder Wasser-Alkohol-Gemisch gelöst oder dispergiert, mit einer katalytischen Menge einer anorganischen oder organischen Säure und einem Aldehyd oder Aldehydgemisch versetzt und erwärmt. Die erhaltene Polymerlösung, die gegebenenfalls ein Antioxidationsmittel enthält, kann direkt zur Herstellung der erfindungsgemäßen Gemische eingesetzt werden, oder das Polymere kann durch Eintropfen in einen Nichtlöser ausgefällt und gereinigt werden.

Bei der zweiten Ausführungsform wird das Pfropfpolymere in Wasser gelöst und mit einem Aldehyd oder Aldehydgemisch versetzt. Dann wird bei niedriger Temperatur eine wäßrige Lösung einer anorganischen oder starken organischen Säure, gegebenenfalls unter Zusatz eines Netzmittels, und eines Antioxidationsmittels zugetropft. Dabei fällt das acetalisierte Pfropfpolymere häufig aus. Die Reaktion wird bei erhöhter Temperatur (etwa 20 - 60° C) vervollständigt. Das isolierte Polymere wird durch Waschen mit Wasser oder durch Umfällen gereinigt.

Zur Herstellung der Pfropfpolyvinylacetale in wäßrigem Medium werden nach bekannten Methoden vorzugsweise 1 bis 50, insbesondere 5 bis 20 gew.-%ige, wäßrige Lösungen der Pfropfpolyvinylalkohole vorzugsweise in der Wärme hergestellt, der Säurekatalysator zugesetzt, die Lösungen anschließend auf Temperaturen unterhalb 25 °C abgekühlt und die Acetalisierungsreaktion durch Zudosieren des Aldehyds, vorzugsweise innerhalb von 3 bis 300 Minuten, unter starkem Rühren durchgeführt. Wegen des bekanntermaßen meist nicht vollständigen Aldehydumsatzes wird im allgemeinen mit Aldehydüberschuß, bevorzugt 10 bis 20 mol-%igem Überschuß, gearbeitet.

In einer bevorzugten Verfahrensvariante wird die wäßrige Lösung vor dem Reaktionsbeginn bei Temperaturen von 0 bis 5 °C mindestens 30 Minuten stehengelassen und dann in Gang gesetzt, wonach sich das gebildete Pfropfpolyvinylacetal alsbald meist pulverförmig abscheidet. Zur Vervollständigung der Reaktion wird das Reaktionsgemisch langsam auf Raumtemperatur erwärmt, und es wird gegebenenfalls eine ca. 1 bis 3 Stunden dauernde Nachreaktion bei höheren Temperaturen, z. B. bei 25 bis 70 °C, angeschlossen. Die zu verwendende Menge Säurekatalysator richtet sich u. a. nach dem angestrebten Acetalisierungsgrad und kann vorzugsweise bis zu 1,1 mol, bezogen auf den molaren Gehalt an Vinylalkoholeinheiten, betragen.

Das gebildete Pfropfpolyvinylacetal wird abgesaugt, mit schwach alkalisch eingestelltem Wasser (pH 9 bis 12) gewaschen und getrocknet. Acetalisierungsprodukte, die sich aus der wäßrigen Reaktionslösung nicht abscheiden, können nach Zusatz von Fällungsmitteln isoliert, gereinigt und getrocknet werden.

Grundsätzlich ist die Acetalisierung auch in organischen Lösemitteln durchführbar.

Als Lösemittel eignen sich mit Wasser mischbare Lösemittel, insbesondere wasserlösliche Alkohole, z. B. Ethanol und/oder Methanol, ggf. unter Zusatz von Wasser.

Als Säurekatalysatoren werden vorzugsweise organische Sulfonsäuren, z. B. Toluolsulfonsäuren, ferner Mineralsäuren, z. B. Schwefelsäure, Phosphorsäure, Salzsäure oder gegebenenfalls Salpetersäure, verwendet. Phosphorsäure und Salzsäure werden bevorzugt.

Zur Herstellung in organischen Lösemitteln werden der Säurekatalysator, der Aldehyd und der Pfropf-Polyvinylalkohol in dem Lösemittel dispergiert oder gelöst und das Gemisch unter Rückfluß erhitzt. Gegebenenfalls kann der Aldehyd auch während des Reaktionsverlaufs zudosiert werden. Die in dem organischen Lösemittel unlöslichen Pfropf-Polyvinylalkohole gehen dabei mit fortschreitender Acetalisierung in Lösung.

Nach Beendigung der Acetalisierungsreaktion wird das Reaktionsprodukt durch Zusatz von unpolaren Lösemitteln, z. B. aliphatischen Kohlenwasserstoffen, oder durch Eingießen der Reaktionslösung in eiskaltes Wasser bzw. eiskaltes Wasser-Alkohol-Gemisch ausgefällt, abgesaugt, mit schwach alkalisch eingestelltem Wasser (pH 9 bis 12) gewaschen und getrocknet.

Die Herstellung der Pfropfpolyvinylacetale ist auch in der älteren deutschen Patentanmeldung P 38 35 840.9 beschrieben.

Die derart erhältlichen Polymeren ergeben in Kombination mit Diazoniumsalz-Polykondensationsprodukten oder Azidoderivaten leicht und schleierfrei entwickelbare Schichten, die je nach Art der Zusammensetzung mit Wasser, wäßrigen Lösungen von anorganischen Salzen und/oder Tensiden oder mit wäßrig-alkalischen Lösungen entwickelt werden können. Die Schichten zeichnen sich durch hohe Abriebbeständigkeit, gute Farbannahme und praxisgerechte Lagerstabilität aus und sind daher für zahlreiche Anwendungsmöglichkeiten einsetzbar, insbesondere für die Herstellung von Flachdruckplatten, Siebdruckschablonen und Photoresists.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten A-N₂X noch andere, nicht lichtempfindliche Einheiten B enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die Diazoniumsalzeinheiten A-N₂X leiten sich bevorzugt von Verbindungen der Formel (R¹-R²-)ₚR³-N₂X ab, wobei
- X: das Anion der Diazoniumverbindung,
- p: eine ganze Zahl von 1 bis 3,
- R¹: einen aromatischen Rest mit mindestens einer zur Kondensation mit aktiver Carbonylverbindung befähigten Position,
- R³: eine Arylengruppe, vorzugsweise eine ggf. substituierte Phenylengruppe,
- R²: eine Einfachbindung oder eine der Gruppen:

-(CH₂)_{q}-NR⁴-,

-O-(CH₂)ᵣ-NR⁴-,

-S-(CH₂)ᵣ-NR⁴-,

-S-CH₂CO-NR⁴-,

-O-R⁵-O-,

- O -

- S - oder

-CO-NR⁴-

bedeuten, worin
- q: eine Zahl von 0 bis 5,
- r: eine Zahl von 2 bis 5,
- R⁴: Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- R⁵: eine Arylengruppe mit 6 bis 12 C-Atomen ist.

Weitere vorteilhafte Polykondensationsprodukte werden erhalten, indem ein ggf. substituiertes Diphenylamindiazoniumsalz zuerst mit einer aromatischen Verbindung R′-O-CH₂-B und danach mit einer aromatischen Verbindung R′-O-CH₂-B-CH₂-O-R′ kondensiert wird, wobei R′ ein Wasserstoffatom, ein Alkyl- oder aliphatischer Acylrest und B der Rest einer der vorstehend aufgezählten kondensationsfähigen Verbindungen ist. Diese Kondensationsprodukte sind in der EP-A 126 875 beschrieben.

Für gewisse Anwendungen sind als lichtempfindliche Verbindungen auch nieder- oder höhermolekulare Azidoderivate geeignet, wobei niedermolekulare Azidoverbindungen mit mindestens zwei Azidogruppen pro Molekül bevorzugt werden. Als Beispiele seien 4,4′-Diazidostilbene, 4,4′-Diazidobenzophenone, 4,4′-Diazidobenzalacetophenone, 4,4′-Diazidobenzalacetone oder 4,4′-Diazidobenzalcyclohexanone genannt. Die Lichtempfindlichkeit derartiger Azidoverbindungen kann gegebenenfalls durch Verwendung geeigneter Sensibilisatoren, z. B. von 1,2-Benzanthrachinon, verstärkt werden. Weiterhin geeignet sind auch solche polyfunktionellen Azide, deren Eigenabsorption durch Konjugation mit Doppelbindungen im Molekül so verschoben ist, daß keine zusätzliche Sensibilisierung bei der Belichtung erforderlich ist. Weitere geeignete Azidoverbindungen sind in der GB-A 790 131, der DE-C 950 618 und der US-A 2 848 328 beschrieben.

Die erfindungsgemäßen Gemische enthalten im allgemeinen 5 bis 90, bevorzugt 10 bis 70 Gew.-% lichtempfindliche Verbindung und 90 bis 10, bevorzugt 75 bis 20 Gew.-% Pfropfpolymeres.

Zur Stabilisierung des lichtempfindlichen Gemischs ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Gemischen können ferner Weichmacher, Haftvermittler und Kontrastbildner zugesetzt werden.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Gemische können ferner Farbstoffe und/oder Pigmente enthalten, die sowohl als Kontrastmittel als auch schichtverfestigend wirken können. In Frage kommende Farbstoffe sind beispielsweise in den US-A 3 218 167 und 3 884 693 angegeben. Besonders geeignet sind z. B. Victoriareinblau FGA, Victoriareinblau BO (C.I. 42595), Malachitgrün, Victoriablau B (C.I. 44045), Renolblau B2G-H (C.I. 74160), Kristallviolett, Fettrot 5B (C.I. 26125), Neozaponblau FLE (C.I. Solvent Blue 70), Brillantblausalz-Acetat, Samaronmarineblau, Orasolblau GN, Zaponechtfeuerrot B (C.I. 13900:1) oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Für gewisse Zwecke kann es vorteilhaft sein, den erfindungsgemäßen lichtempfindlichen Gemischen weitere Polymere in Mengen bis zu 50, vorzugsweise bis zu 20 Gew.-% der oben beschriebenen polymeren Bindemittel zuzusetzen.

Im Rahmen der Erfindung wird folgende gewichtsmäßige Verteilung der wichtigsten Zusätze in dem lichtempfindlichen Gemisch bevorzugt, bezogen auf den Gehalt an nichtflüchtigen Bestandteilen, d. h. die Bestandteile der nach dem Verdampfen des Lösemittels erhaltenen festen lichtempfindlichen Schicht.

| | |
|---|---|
| Bindemittel | 20 bis 90 % |
| lichtempfindliche Verbindung | 10 bis 70 % |
| Säure | 0 bis 10 % |
| Farbstoff oder Pigment | 0 bis 12 % |
| Belichtungskontrastgeber (Farbstoff) | 0 bis 5 % |

Die Beschichtung des Trägermaterials erfolgt aus entsprechenden organischen Lösemitteln oder Lösemittelgemischen, und zwar im allgemeinen durch Gießen, Sprühen oder Eintauchen. Die Art des Auftrags hängt von der gewünschten Schichtdicke ab, wobei die Schichtdicken der trockenen Schicht im allgemeinen zwischen 0,5 und 200 µm liegen.

Als Schichtträger eignen sich z. B. Magnesium, Zink, Kupfer, mechanisch, chemisch und elektrochemisch aufgerauhtes Aluminium, anodisiertes Aluminium, Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden.

Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UV-härtbaren Druckfarben.

Bevorzugt wird das Gemisch zur Herstellung von Flachdruckformen verwendet, wobei als Trägermaterial Aluminium bevorzugt wird. Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxidation. Eine weitere Behandlung dieses Trägermaterials, z. B. mit Polyvinylphosphonsäure, Alkalisilikat, Phosphat, Hexafluorozirkonat, Chromat, Borat, Polyacrylamid und Cellulosederivaten, ist vorteilhaft.

Die Verarbeitung der aus den Gemischen erhaltenen Aufzeichnungsmaterialien erfolgt in bekannter Weise durch bildmäßiges Belichten und Auswaschen der unbelichteten Schichtbereiche mit einem geeigneten Entwickler.

Die Belichtung des Aufzeichnungsmaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch CO₂ Laser, welche bei 10,6 µm emittieren, oder YAG-Laser, die bei 1,06 µm emittieren.

Als Entwicklerlösungen werden Wasser oder neutrale oder alkalische wäßrige Lösungen mit einem pH-Wert im Bereich von 6 bis 14, vorzugsweise 7,5 bis 12, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z. B. bis zu 5, bevorzugt nicht mehr als 2 Gew.-% an mit Wasser mischbaren organischen Lösemitteln enthalten. Bevorzugt werden schwerflüchtige Lösemittel, z. B. araliphatische Alkohole, deren Dampfdruck bei der Handhabung des Entwicklers nicht ins Gewicht fällt. Die Entwicklung kann in bekannter Weise durch Tauchen, Besprühen, Bürsten oder Tamponieren erfolgen. Anschließend kann das entwickelte Material mit einem Konservierungsmittel behandelt werden.

Die erfindungsgemäßen lichtempfindlichen Aufzelchnungsmaterialien weisen gute Wiedergabeeigenschaften und praxisgerechte Lagerstabilität auf. Sie lassen sich leicht und schleierfrei mit Entwicklerlösungen verarbeiten, die praktisch umweltneutral sind.

Von besonderem Vorteil ist die hohe Druckauflage, die mit den aus dem erfindungsgemäßen Material hergestellten Druckformen erreicht wird sowie die gute Farbannahme. Die Druckschablonen weisen ebenfalls eine hohe Resistenz gegenüber alkalischen Entwicklern und anderen Verarbeitungslösungen auf.

Im folgenden wird zunächst die Herstellung der in den Beispielen eingesetzten Polyvinylacetale beschrieben.
a) Herstellung von Polyurethan-Pfropfgrundlagen
   In einem Reaktionsgefäß mit Rührwerk wurden unter Stickstoffatmosphäre jeweils die Diolkomponente und der Katalysator vorgelegt, und das Gemisch wurde auf eine Reaktionstemperatur zwischen 65 und 100 °C erwärmt. Die Diisocyanatkomponente wurde anschliessend so zudosiert, daß die Temperatur des Reaktionsgemischs 120 °C, vorzugsweise 100 °C, nicht überschritt. Nach vollständiger Zudosierung der Diisocyanatkomponente wurde zur Vervollständigung der Reaktion bis zu zwei Stunden auf 80 bis 100 °C nacherwärmt. Die Vollständigkeit des Umsatzes und damit das Ende der Reaktion wurden durch Analyse des Diisocyanatverbrauchs nach üblichen Methoden (z. B. IR-Spektroskopie, Titration) ermittelt.
   Einzelheiten über die Zusammensetzung der Reaktionsgemische der Beispiele sowie das berechnete mittlere Molekulargewicht (M̅_{ber} der resultierenden Polyurethane (PU) können der Tabelle 1 entnommen werden. Die Molekulargewichte ergeben sich aus dem Molverhältnis Diolkomponente/Diisocyanat unter der Annahme einer vollständigen Umsetzung der NCO-Gruppen.

**Tabelle 1**

| Polyurethan (PU) | Diolkomponente PEG/Bu (Molverhältnis | Reaktionstemp. °C | Molverhältnis Diolkomponente/Diisocyanat | M̅_{ber} |
|---|---|---|---|---|
| A | 7 : 3 | 80 | 1 : 0,9 | 6470 |
| B | 7 : 3 | 72 | 1 : 0,9 | 6470 |
| C | 3 : 2 | 78 | 1 : 0,97 | 18300 |
| D | 7 : 3 | 75 | 1 : 0,97 | 19900 |
| E | 7 : 3 | 78 | 1 : 0,95 | 13200 |

Alle Produkte werden mit Isophorondiisocyanat als Diisocyanatkomponente hergestellt. Als Katalysator wurde bei allen Produkten 1,4-Dimethylpiperazin in einer Menge von 0,48 mol-%, bezogen auf Diisocyanat, eingesetzt.
- PEG: = Polyethylenglykol, Molgewicht 600
- Bu: = 1,4-Butandiol

b) Herstellung der Pfropfpolymeren
   Die Polyurethan-Pfropfgrundlage wurde jeweils in einem Reaktionsgefäß unter Stickstoffatmosphäre aufgeschmolzen bzw. unter Zusatz geringer Mengen Methanol gelöst und auf eine Temperatur von etwa 60 bis 100 °C erwärmt. Die zu pfropfenden Monomeren wurden, ggf. gelöst in einem Lösemittel (z. B. Methanol), einschließlich des in den Monomeren gelösten radikalischen Initiators so langsam zu der Polyurethan-Pfropfgrundlage dosiert, daß die Bildung von Homopolymerisat weitgehend unterblieb.
   Die Temperatur des Reaktionsgemischs sollte 120 °C, besser noch 100 °C nicht überschreiten. Nach Beendigung der Nachreaktion wurde überschüssiges Restmonomeres durch azeotrope Destillation mit Methanol entfernt. Die Zusammensetzung der einzelnen Reaktionsgemische sowie die Reaktionsparameter sind in Tabelle 2 angegeben.

**Tabelle 2**

| Pfropfpolymeres | PU | VAc g/g PU | Cr g/g PU | Start Temp. °C | Zudos-Zeit Min. | Nachreakt. Min. | Gepfr. Monom. Gew.-% | Jₒ ml/g | Berechnetes Mol-Gew. |
|---|---|---|---|---|---|---|---|---|---|
| AV | A | 4 | 0 | 75 | 420 | 45 | 79,8 | 21,9 | 31300 |
| BV | B | 2,32 | 0 | 73 | 420 | 45 | 69,3 | 18,3 | 21000 |
| CV | C | 3,16 | 0 | 75 | 300 | 45 | 74,7 | 26,3 | 72500 |
| DV | D | 3,16 | 0 | 75 | 420 | 45 | 74,5 | 28,7 | 78000 |
| EVCr | E | 3,13 | 0,027 | 75 | 300 | 45 | 75,1 | 30,5 | 53000 |
| EVCr' | E | 3,03 | 0,126 | 75 | 300 | 45 | 75,3 | 31,5 | 53000 |
| VAc = Vinylacetat Jₒ = Grenzviskositätszahl (intrinsic viscosity) Cr = Crotonsäure | | | | | | | | | |

Alle Produkte wurden unter Verwendung von 0,2 mol-% Dibenzoylperoxid (bezogen auf das eingesetzte Monomere) hergestellt. Die Grenzviskositätszahlen wurden im Ostwaldviskosimeter in Tetrahydrofuran bei 25 °C ermittelt, die vermessenen Konzentrationen wurden so gewählt, daß eine Hagenbachkorrektur nicht durchgeführt werden mußte. Die gepfropfte Monomermenge in Gew.-% bezieht sich auf das Gewicht des Gesamtpolymeren.
c) Verseifung der Pfropfpolymeren
   Die Pfropfpolymerisate aus Tabelle 2 wurden innerhalb zwei Stunden bei Raumtemperatur umgeestert bzw. verseift. Hierzu wurden die Produkte zu 50 %iger Lösung in Methanol gelöst und mit methanolischer Natronlauge (10 %ig) versetzt. Es wurden je nach Alkalimenge und dem Pfropfungsgrad des Pfropfpolymerisats polymere Hydrolyseprodukte mit unterschiedlichem Hydrolysegrad erhalten. Teilverseifungen wurden unter Mitverwendung von Wasser durchgeführt. Die erhaltenen Gele wurden mittels üblicher Mühlen granuliert, das Granulat mit Methanol gewaschen (ggf. unter Zusatz von Essigsäure zur Neutralisation der Natronlauge) und getrocknet. Die Verfahrensbedingungen und Ergebnisse sind in Tabelle 3 aufgeführt.

**Tabelle 3**

| Pfropfpolyvinylalkohol | Pfropfpolyvinylacetat | mol-% NaOH je Estereinheit | mol-% H₂O je Estereinheit | Hydrolysegrad in % | M̅_{ber} |
|---|---|---|---|---|---|
| F | AV | 1,92 | 0 | 98,2 | 22 000 |
| G | BV | 5,0 | 0 | 98,9 | 14 000 |
| H | CV | 1,92 | 0 | 98 | 47 000 |
| I | DV | 1,97 | 0 | 98,4 | 44 000 |
| K | CV | 0,56 | 12,53 | 60 | 56 600 |
| L | CV | 0,5 | 11,13 | 56,5 | 57 600 |
| M | EVCr | 1,59 | 0 | 92,7 * | 40 000 |
| N | EVCr' | 2,0 | 0 | 94,5 * | 36 000 |

| | | | | | |
|---|---|---|---|---|---|
| * ermittelt durch Bestimmung der nach der Verseifung vorhandenen Säure; dabei wird auch die im Polymeren enthaltene Crotonsäure erfaßt. | | | | | |

d) Herstellung der Pfropf-Polyvinylacetale
   Die Pfropfpolymerisate aus Tabelle 3 werden unter leichtem Erwärmen in etwa der achtfachen Menge destillierten Wassers gelöst. Bei Raumtemperatur wird die entsprechende Menge Aldehyd und eine geringe Menge 2,6-Di-tert.-butyl-4-methyl-phenol zugegeben. Zu dieser Lösung wird unter gutem Rühren eine Lösung aus einer kleinen Menge Natriumoctylsulfat, 1/3 der Gewichtsmenge des Aldehyds an konzentrierter Salzsäure und Wasser zugetropft. Nach einer Stunde Rühren bei Raumtemperatur wird auf 40 °C erwärmt und noch 2 Stunden gerührt. Dann wird nochmals konzentrierte Salzsäure in gleicher Gewichtsmenge wie der Aldehyd zugesetzt und weitere 2 Stunden bei 40 °C gerührt. Nach Abkühlen auf Raumtemperatur wird die wäßrige Phase vom ausgefallenen Polymeren abdekantiert, das Polymere in Ethanol gelöst und durch Eingießen in einen Überschuß Wasser ausgefällt. Das Polymere wird im Vakuumtrockenschrank bei 40 °C bis zur Gewichtskonstanz getrocknet.

**Tabelle 4**

| Pfropfpolyvinylacetal | Pfropfpolyvinylalkohol | Aldehyd | OH-Zahl |
|---|---|---|---|
| O | F | Bu | 370 |
| P | G | Bu | 290 |
| Q | H | Pr | 336 |
| R | K | Bu | 124 |
| S | H | Ac + Bu 1) | 144 |
| T | H | Bz + Pr 2) | 328 |
| U | H | Bz | 393 |
| V | H | Bu | 201 |
| W | M | Pr | 401 |
| X | N | Bu | 351 |
| Bu = n-Butyraldehyd Ac = Acetaldehyd Bz = Benzaldehyd Pr = Propionaldehyd | | | |

| | | | |
|---|---|---|---|
| 1) Molverhältnis 4,6 : 1 | | | |
| 2) Molverhältnis 1 : 1 | | | |

Die folgenden Beispiele erläutern bevorzugte Ausführungsformen der Erfindung. Die Mengen sind zumeist in Gewichtsteilen (Gt) angegeben. Prozentangaben und Mengenverhältnisse sind in Gewichtseinheiten zu verstehen, wenn nichts anderes angegeben ist.

### Beispiel 1

Eine Beschichtungslösung aus
2,6 Gt des Polymeren I,
2,6 Gt eines Diazoniumsalz-Polykondensationsprodukts aus 1 mol 3-Methoxy-diphenylamin-4-diazoniumsulfat und 1 mol 4,4′-Bis-methoxymethyldiphenylether, isoliert als Methansulfonat,
0,117 Gt Phosphorsäure (85 %ig) und
0,34 Gt Basonyl-Rot 540 (C.I. 45 170) in
160 Gt dest. Wasser
wird auf eine 0,3 mm starke, in Salpetersäure elektrochemisch aufgerauhte, in Schwefelsäure anodisierte und mit einer 0,1 %igen wäßrigen Lösung von Polyvinylphosphonsäure nachbehandelte Aluminiumfolie derart aufgebracht, daß ein Trockenschichtgewicht von 0,52 g/m² erhalten wird.

Die so erhaltene lichtempfindliche Schicht wird unter einer Standard-Negativvorlage 36 Sekunden mit einer Metallhalogenid-Lampe von 5 kW Leistung belichtet. Die belichtete Schicht zeigt einen klaren Kontrast zwischen den belichteten und unbelichteten Bereichen und wird durch Abspritzen mit einem Wasserstrahl entwickelt, wobei die nichtbelichteten Schichtbereiche innerhalb kurzer Zeit sauber entfernt werden. Anschließend wird getrocknet. Die feinsten Elemente der Vorlage werden in der Kopie wiedergegeben.

### Beispiel 2

Eine Beschichtungslösung aus
2,5 Gt des Polymeren O,
0,86 Gt eines Diazoniumsalz-Polykondensationsprodukts aus 1 mol 3-Methoxy-diphenylamin-4-diazoniumsulfat und 1 mol 4,4′-Bis-methoxymethyldiphenylether, isoliert als Mesitylensulfonat,
0,10 Gt Phosphorsäure (85 %ig),
0,028 Gt Phenylazodiphenylamin und
0,13 Gt Victoriareinblau FGA (C.I. Basic Blue 81) in
22,9 Gt Tetrahydrofuran und
118 Gt 2-Methoxy-ethanol
wird auf eine wie in Beispiel 1 vorbehandelte Aluminiumfolie so aufgebracht, daß ein Trockenschichtgewicht von 1,0 g/m² erhalten wird. Die Schicht wird analog zu Beispiel 1 30 s belichtet. Die Entwicklung erfolgt mit einer Entwicklerlösung folgender Zusammensetzung:
5,0 Gt Natriumoctylsulfat,
1,0 Gt Natriummetasilikat x 5 H₂O,
94,0 Gt dest. Wasser.

Die nichtbelichteten Schichtbereiche werden innerhalb kurzer Zeit sauber entfernt. Die Platte wird anschließend mit Wasser abgespült und getrocknet. In der Kopie werden die feinsten Elemente der Vorlage wiedergegeben. Die derart erhaltenen Druckplatten liefern an einer Bogenoffsetmaschine eine Druckauflage von mehr als 200.000 Bogen.

### Beispiel 3

Eine Beschichtungslösung aus
3,4 Gt des Polymeren P,
1,1 Gt des in Beispiel 2 angegebenen Diazoniumsalz-Polykondensationsprodukts,
0,05 Gt Phosphorsäure (85 %ig),
0,11 Gt Metanilgelb (C.I. 13065) und
0,15 Gt Victoriablau B (C.I. 44045) in
160 Gt 2-Methoxy-ethanol
wird auf eine wie in Beispiel 1 vorbehandelte Aluminiumfolie so aufgebracht, daß ein Trockenschichtgewicht von 0,9 g/m² erhalten wird. Die Schicht wird wie in Beispiel 2 30 s belichtet. Die Entwicklung erfolgt mit einer Entwicklerlösung folgender Zusammensetzung:
5,0 Gt Natriumoctylsulfat,
1,5 Gt Natriummetasilikat x 5 H₂O,
1,5 Gt Trinatriumphosphat x 12 H₂O,
92,0 Gt dest. Wasser.

Die nichtbelichteten Stellen werden sofort entfernt. Die Weiterbehandlung erfolgt wie in Beispiel 2. Auch hier werden in der Kopie die feinsten Elemente der Vorlage wiedergegeben. Die erhaltene Druckplatte liefert an einer Bogenoffsetmaschine eine Druckauflage von mehr als 250.000 Bogen.

### Beispiel 4

Eine Beschichtungslösung aus
3,6 Gt des Polymeren L,
1,8 Gt des in Beispiel 2 angegebenen Diazoniumsalz-Polykondensationsprodukts,
0,2 Gt Phosphorsäure (85 %ig),
0,1 Gt Kristallviolett (C.I. 42555) und
0,06 Gt Phenylazodiphenylamin in
150 Gt 2-Methoxy-ethanol
wird auf eine wie in Beispiel 1 vorbehandelte Aluminiumfolie so aufgebracht, daß ein Trockenschichtgewicht von 1,2 g/m² erhalten wird.

Nach 15 s Belichtung wird die Schicht mit einer Entwicklerlösung folgender Zusammensetzung:
5,0 Gt Natriumoctylsulfat,
1,5 Gt Natriummetasilikat x 5 H₂O,
1,0 Gt Trinatriumphosphat x 12 H₂O,
0,5 Gt Dinatriumhydrogenphosphat x 1 H₂O
92,0 Gt Wasser
mittels eines Plüschtampons behandelt, wobei die nicht belichteten Schichtbereiche sauber entfernt werden, und anschließend mit Wasser gespült und getrocknet.

In der Kopie ist die Stufe 4 eines Silberfilm-Halbtonstufenkeils mit einem Dichteumfang von 0,15 bis 1,50, wobei die Dichteinkremente 0,15 betragen, noch voll gedeckt. Die derart erhaltene Druckplatte liefert an einer Bogenoffsetmaschine eine Auflage von 220.000 Drucken.

### Beispiel 5

Eine Beschichtungslösung aus
2,5 Gt des Polymeren R,
2,5 Gt des in Beispiel 2 angegebenen Diazoniumsalz-Polykondensationsprodukts,
0,118 Gt Phosphorsäure (85 %ig),
0,045 Gt Phenylazodiphenylamin und
0,10 Gt Kristallviolett in
160 Gt 2-Methoxy-ethanol
wird auf den in Beispiel 1 angegebenen Träger so aufgebracht, daß ein Trockenschichtgewicht von 1,0 g/m² erhalten wird. Nach Belichtung und Entwicklung wie in Beispiel 2 erhält man eine Kopie, die beim Einspannen in eine Druckmaschine einige Tausend guter Drucke ergibt.

### Beispiel 6

Eine Beschichtungslösung aus
1,3 Gt des Polymeren Q,
1,3 Gt des in Beispiel 2 angegebenen Diazoniumsalz-Polykondensationsprodukts,
0,059 Gt Phosphorsäure (85 %ig),
0,023 Gt Phenylazodiphenylamin und
0,34 Gt Renolblau B2G-H (C.I. 74160) in
90 Gt 2-Methoxy-ethanol
wird auf den in Beispiel 1 angegebenen Träger so aufgebracht, daß ein Trockenschichtgewicht von 1,1 g/m² erhalten wird. Nach Belichtung und Entwicklung wie in Beispiel 2 erhält man eine Kopie, in der die Stufe 4 des Halbtonstufenkeils (Beispiel 4) noch voll gedeckt ist. Die Druckplatte liefert an einer Bogenoffsetmaschine eine Auflage von 240.000 Drucken.

### Beispiel 7

Das Bindemittel S wird in der in Beispiel 6 beschriebenen Beschichtungslösung anstelle des Polymeren Q eingesetzt.

Diese Beschichtungslösung wird auf eine wie in Beispiel 1 vorbehandelte Aluminiumfolie aufgebracht und getrocknet. Das Schichtgewicht beträgt etwa 1 g/m².

Die lichtempfindliche Schicht wird unter einer Negativvorlage 30 Sekunden mit der in Beispiel 1 beschriebenen Lampe belichtet und dann mit dem in Beispiel 3 angegebenen Entwickler entwickelt.

Bereits nach wenigen Sekunden lösen sich die Nichtbildstellen der Kopierschicht ab, und nach Überwischen mittels eines Plüschtampons wird mit Wasser abgespült und getrocknet. Die Kopie zeigt gleiche Eigenschaften wie die in Beispiel 3 beschriebene. In einer Bogenoffsetmaschine liefert die Platte 210.000 gute Drucke.

### Beispiel 8

Mit dem Polymeren T wird eine Beschichtungslösung der in Beispiel 6 beschriebenen Zusammensetzung hergestellt. Die Verarbeitung erfolgt analog zu Beispiel 6. Nach bildmäßiger Belichtung (30 Sekunden) und Entwicklung erhält man eine Kopie mit sehr hoher Auflösung. Nach dem Einspannen in eine Bogenoffsetmaschine liefert die Druckform mehr als 200.000 Drucke sehr guter Qualität.

### Beispiel 9

Eine mit dem Polymeren U analog Beispiel 2 hergestellte Beschichtungslösung wird auf vorbehandelte Aluminiumfolie so aufgebracht, daß ein Trockenschichtgewicht von 0,95 g/m² erhalten wird.

Die Schicht wird analog zu Beispiel 1 30 s belichtet. Die Entwicklung erfolgt mit einer Entwicklerlösung folgender Zusammensetzung:
5,0 Gt Natriumoctylsulfat,
1,5 Gt Natriummetasilikat x 5 H₂O,
1,0 Gt Trinatriumphosphat x 12 H₂O,
1,0 Gt Phenoxyethanol
91,5 Gt Wasser.

Bereits nach wenigen Sekunden Überwischen mittels eines Plüschtampons lösen sich die Nichtbildstellen der Schicht ab; es wird mit Wasser abgespült und getrocknet. Man erhält eine Kopie mit hoher Auflösung.

### Beispiel 10

Die im Beispiel 6 beschriebene Schicht wird auf ihre Lagerfähigkeit geprüft. Dazu werden von dem dort beschriebenen lichtempfindlichen Gemisch Platten hergestellt und diese 1 bis 4 Stunden in einem Trockenschrank bei 100 °C gelagert. Nach der Wärmelagerung werden die Platten bildmäßig belichtet und mit dem in Beispiel 2 beschriebenen Entwickler entwickelt. Zum Sichtbarmachen von verbliebenen Schichtresten (Ton) in den Nichtbildbereichen werden die getrockneten Platten mit Schutzfarbe eingefärbt.

Die eine und zwei Stunden gelagerten Platten lassen sich noch einwandfrei entwickeln. Sie zeigen keine Verlängerung des Halbtonstufenkeils. Nach dreistündiger Wärmelagerung zeigt die Schicht eine Verlängerung des Halbtonstufenkeils um eine halbe Stufe. Die Entwicklung ist unwesentlich verzögert. Bei der vier Stunden gelagerten Platte zeigt der Halbtonstufenkeil eine Zunahme um 1,5 Stufen. Die Entwicklung ist etwas verzögert. Die Ergebnisse zeigen, daß die erfindungsgemäßen Gemische gegen Lagerung in der Wärme relativ beständig sind.

### Beispiel 11

Eine Beschichtungslösung aus
1,1 Gt des Polymeren V,
1,1 Gt 4,4′-Diazido-stilben-2,2′-disulfonsäure-Natriumsalz,
0,15 Gt Rhodamin 6 GDN extra (C.I. 45160),
0,05 Gt Michlers Keton in
15 Gt Tetrahydrofuran,
10 Gt Wasser und
50 Gt 2-Methoxy-ethanol
wird auf den in Beispiel 1 beschriebenen Träger so aufgebracht, daß ein Trockenschichtgewicht von 0,8 g/m² erhalten wird. Die Kopierschicht wird 35 Sekunden unter einer Negativvorlage belichtet und anschließend mit reinem Wasser entwickelt, wobei die Nichtbildstellen innerhalb kurzer Zeit entfernt werden.

### Beispiel 12-18

Anhand der nachstehenden Beispiele soll verdeutlicht werden, daß die erfindungsgemäßen lichtempfindlichen Schichten gegenüber solchen, die handelsübliche Polyvinylacetale enthalten, leichter mit wäßrigen Entwicklern verarbeitbar sind und dabei gleichzeitig kopier-und drucktechnische Eigenschaften aufweisen, die denen der Vergleichsbeispiele überlegen oder zumindest ebenbürtig sind.

Zu diesem Zweck werden 6 Beschichtungslösungen hergestellt, die sich lediglich im verwendeten Polymeren unterscheiden:
3,6 Gt des jeweiligen Polymeren,
1,8 Gt des in Beispiel 2 angegebenen Diazoniumsalz-Polykondensationsprodukts,
0,2 Gt Phosphorsäure (85 %ig),
0,1 Gt Kristallviolett (C.I. 42555) und
0,06 Gt Phenylazodiphenylamin in
150 Gt 2-Methoxy-ethanol.

Die jeweils verwendeten Polymeren, deren OH-Zahlen sowie die Entwickelbarkeit, Auflösung, Farbannahme und Druckauflage der entsprechenden lichtempfindlichen Schichten sind in der nachstehenden Tabelle 5 wiedergegeben. Alle Schichten wurden zu einem Trockenschichtgewicht von 1,0 g/m² auf einen elektrolytisch in Salpetersäure aufgerauhten, anodisierten und mit Polyvinylphosphonsäure nachbehandelten Aluminiumträger aufgebracht.

**Tabelle 5**

| | | | | | | | |
|---|---|---|---|---|---|---|---|
| Beispiel | 12 | 13 | 14 | 15(V) | 16(V) | 17(V) | 18(V) |
| Polymeres | O | L | Q | But | But | But | For |
| Molekulargewicht | 30.400 | 57.600 | 62.300 | 85.000 | 85.000 | 85.000 | 30.000 |
| OH-Zahl | 370 | 347 | 336 | 300 | 220 | 160 | 85 |

| Entwickler | | | | | | | |
|---|---|---|---|---|---|---|---|
| (a) | + | + | + | - | - | - | - |
| (b) | + | + | + | - | - | - | - |
| (c) | + | (+) | (+) | (+) | - | - | + |
| (d) | + | + | + | - | - | - | - |
| (e) | (+) | (+) | (+) | + | + | (+) | (+) |
| Farbannahme | gut | gut | gut | gut | gut | gut | gut |
| Auflage | 200.000 | 220.000 | 240.000 | 120.000 | 120.000 | 120.000 | 220.000 |
| But = handelsübliche Polyvinylbutyrale For = handelsübliches Polyvinylformal | | | | | | | |

### Entwicklerzusammensetzung:

(a) Entwickler wie im Beispiel 2,
(b) 0,2 Gt Natriummetasilikat x 9 Wasser,
   4 Gt Dinatriumhydrogenphosphat x 12 Wasser,
   3,5 Gt Trinatriumphosphat x 12 Wasser,
   1,5 Gt Kaliumtetraborat x 4 Wasser,
   2 Gt Kaliumoxalat x 1 Wasser,
   88,8 Gt Wasser.
(c) 1,0 Gt Natriumtetraborat x 4 Wasser,
   2,0 Gt Natriumoctylsulfat,
   15 Gt Natriumsalicylat,
   2,5 Gt Natriumbenzoat,
   5,0 Gt Trinatriumcitrat x 2 Wasser,
   1,0 Gt Phenoxyethanol,
   73,5 Gt Wasser.
(d) 1 Gt NaOH,
   4 Gt Pelargonsäure,
   12 Gt Ethylenoxid/Propylenoxid-Copolymeres,
   4 Gt Natriumtetrapolyphosphat,
   79 Gt Wasser.
(e) 0,5 Gt Ethylencarbonat,
   15 Gt 2-Hydroxy-ethylacetat,
   10 Gt Glycerin,
   1 Gt Natriumbenzoat,
   0,5 Gt Benzoesäure,
   50 Gt Propylenglykolmonomethylether
   23,0 Gt Wasser.

- + =: Entwickler gut geeignet,
- - =: Entwickler nicht geeignet, da keine Schichtdifferenzierung
- (+) =: Entwickler wenig geeignet, da schlechte Schichtdifferenzierung oder Angriff der belichteten Schicht
- (V) =: Vergleichsbeispiel

Aus diesen Beispielen geht hervor, daß die erfindungsgemäßen lichtempfindlichen Gemische im Gegensatz zu den Gemischen der Vergleichsbeispiele leicht mit wäßrigen Lösungen entwickelbar sind. Die letzteren lassen sich erst mit lösemittelhaltigen Entwicklern verarbeiten.

### Beispiel 19

Aus 1,1 Gt des Polymeren I,
1,1 Gt 4,4′-Diazido-stilben-2,2′-disulfonsäure-Dinatriumsalz,
0,15 Gt Basonylrot 540 und
0,05 Gt Michlers Keton in
50 Gt Methanol und
50 Gt Wasser
wird eine Beschichtungslösung hergestellt, die auf einen drahtgebürsteten Aluminiumträger so aufgebracht wird, daß ein Trockenschichtgewicht von 0,9 g/m² erhalten wird. Die Schicht wird 35 Sekunden belichtet und durch Besprühen mit reinem Wasser entwickelt.

### Beispiel 20

Das Polymere W wird in der in Beispiel 2 beschriebenen Beschichtungslösung anstatt des dort verwendeten Bindemittels eingesetzt und auf den in Beispiel 1 beschriebenen Träger aufgeschleudert. Das Schichtgewicht beträgt nach dem Trocknen 0,96 g/m². Die lichtempfindliche Schicht wird 30 Sekunden unter einer Standard-Negativvorlage belichtet und die unbelichteten Bereiche mit der Entwicklerlösung aus Beispiel 3 sofort entfernt. Die erhaltene Druckplatte zeichnet sich durch eine sehr gute Auflösung und Farbannahme aus.

### Beispiel 21

In die Beschichtungslösung aus Beispiel 1 wird statt des dort verwendeten Bindemittels das Polymere X eingearbeitet und auf die dort beschriebene Aluminiumfolie zu einem Trockenschichtgewicht von 1,1 g/m² aufgebracht. Die belichtete Schicht wird durch Besprühen mit reinem Wasser sofort entwickelt. Es wird eine Druckplatte mit hoher Auflösung erhalten.

## Patentansprüche

1. Lichthärtbares Gemisch, das als lichtempfindliche Verbindung ein Diazoniumsalz-Polykondensationsprodukt oder eine organische Azidoverbindung und als Bindemittel ein hochmolekulares Polymeres enthält, das Vinylalkoholeinheiten aufweist, dadurch gekennzeichnet, daß das Polymere ein Pfropfmischpolymerisat mit einem Polyurethan als Pfropfgrundlage und aufgepfropften Ketten ist, die Vinylalkoholeinheiten enthalten.

2. Lichthärtbares Gemisch nach Anspruch 1, dadurch gekennzeichnet, daß die aufgepfropften Ketten ferner Vinylestereinheiten enthalten.

3. Lichthärtbares Gemisch nach Anspruch 1 oder 2, dadurch gekennzeichnet, daß die aufgepropften Ketten ferner Vinylacetaleinheiten enthalten.

4. Lichthärtbares Gemisch nach Anspruch 3, dadurch gekennzeichnet, daß die Vinylacetaleinheiten von einem aliphatischen oder cycloaliphatischen Aldehyd abgeleitet sind.

5. Lichthärtbares Gemisch nach einem der Ansprüche 1 bis 4, dadurch gekennzeichnet, daß die aufgepfropften Ketten ferner Einheiten von weiteren ethylenisch ungesättigten, mit Vinylestern copolymerisierbaren Monomeren enthalten.

6. Lichthärtbares Gemisch nach Anspruch 1, dadurch gekennzeichnet, daß das Polyurethan ein Polyadditionsprodukt aus Diisocyanaten und Diolen ist.

7. Lichthärtbares Gemisch nach Anspruch 6, dadurch gekennzeichnet, daß als Diol ein aliphatisches Diol mit 2 bis 12 Kohlenstoffatomen, ein cycloaliphatisches Diol mit 5 bis 10 Kohlenstoffatomen oder ein aliphatisches Polydiol mit einem Molekulargewicht von 200 bis 10.000 eingesetzt wird.

8. Lichthärtbares Gemisch nach Anspruch 7, dadurch gekennzeichnet, daß als Diol ein Gemisch aus 1 mol Polydiol und 0,1 bis 0,7 mol niedermolekularem aliphatischem Diol eingesetzt wird.

9. Lichthärtbares Gemisch nach Anspruch 6, dadurch gekennzeichnet, daß das Diisocyanat ein aliphatisches Diisocyanat mit 4 bis 15 Kohlenstoffatomen oder ein cycloaliphatisches Diisocyanat mit 7 bis 15 Kohlenstoffatomen ist.

10. Lichthärtbares Gemisch nach Anspruch 1 oder 6, dadurch gekennzeichnet, daß das Polyurethan ein Molekulargewicht von 200 bis 100.000 hat.

11. Lichthärtbares Gemisch nach Anspruch 1, dadurch gekennzeichnet, daß das Diazoniumsalz-Polykondensationsprodukt aus wiederkehrenden Einheiten A-N₂X und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

12. Lichthärtbares Gemisch nach Anspruch 11, dadurch gekennzeichnet, daß die Einheiten A-N₂X sich aus Verbindungen der allgemeinen Formel
(R¹-R²-)ₚR³-N₂X
ableiten, wobei
X das Anion der Diazoniumverbindung,
p eine ganze Zahl von 1 bis 3,
R¹ einen aromatischen Rest mit mindestens einer zur Kondensation mit aktiver Carbonylverbindung befähigten Position,
R³ eine Phenylengruppe,
R² eine Einfachbindung oder eine der Gruppen:
-(CH₂)_{q}-NR⁴-,
-O-(CH₂)ᵣ-NR⁴-,
-S-(CH₂)ᵣ-NR⁴-,
-S-CH₂CO-NR⁴-,
-O-R⁵-O-,
- O -
- S - oder
-CO-NR⁴-
bedeuten, worin
q eine Zahl von 0 bis 5,
r eine Zahl von 2 bis 5,
R⁴ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
R⁵ eine Arylengruppe mit 6 bis 12 C-Atomen ist.

13. Lichthärtbares Gemisch nach Anspruch 1, dadurch gekennzeichnet, daß die organische Azidoverbindung mindestens zwei Azidogruppen im Molekül enthält.

14. Lichthärtbares Aufzeichnungsmaterial aus einem Schichtträger und einer lichtempfindlichen Schicht, dadurch gekennzeichnet, daß die lichtempfindliche Schicht aus einem Gemisch gemäß Anspruch 1 besteht.

## Claims

1. A photocurable mixture which contains a diazonium salt polycondensation product or an organic azido compound as the photosensitive compound and a high-molecular weight polymer having vinyl alcohol units as the binder, wherein said polymer is a graft polymer obtained from a polyurethane graft backbone, onto which chains containing vinyl alcohol units are grafted.

2. The photocurable mixture as claimed in claim 1, wherein the grafted-on chains furthermore contain vinyl ester units.

3. The photocurable mixture as claimed in claim 1 or 2, wherein the grafted-on chains furthermore contain vinyl acetal units.

4. The photocurable mixture as claimed in claim 3, wherein the vinyl acetal units are derived from an aliphatic or cycloaliphatic aldehyde.

5. The photocurable mixture as claimed in any of claims 1 to 4, wherein the grafted-on chains furthermore contain units of other ethylenically unsaturated monomers which are copolymerizable with vinyl esters.

6. The photocurable mixture as claimed in claim 1, wherein the polyurethane is a polyaddition product obtained from diisocyanates and diols.

7. The photocurable mixture as claimed in claim 6, wherein the diol is an aliphatic diol having 2 to 12 carbon atoms, a cycloaliphatic diol having 5 to 10 carbon atoms or an aliphatic polydiol having a molecular weight between 200 and 10,000.

8. The photocurable mixture as claimed in claim 7, wherein the diol is a mixture comprising 1 mol of polydiol and 0.1 to 0.7 mol of low molecular weight aliphatic diol.

9. The photocurable mixture as claimed in claim 6, wherein the diisocyanate is an aliphatic diisocyanate having 4 to 15 carbon atoms or a cycloaliphatic diisocyanate having 7 to 15 carbon atoms.

10. The photocurable mixture as claimed in claim 1 or 6, wherein the polyurethane has a molecular weight between 200 and 100,000.

11. The photocurable mixture as claimed in claim 1, wherein the diazonium salt polycondensation product comprises recurrent units A-N₂X and B, which are linked by intermediate members, preferably methylene groups, which are derived from condensible carbonyl compounds, with A being the radical of an aromatic diazonium compound which is capable of condensation with formaldehyade and B being the radical of a compound which is free of diazonium groups and is capable of condensation with formaldehyde, particularly of an aromatic amine, of a phenol, of a phenol ether, of an aromatic thioether, of an aromatic hydrocarbon, of an aromatic heterocyclic compound or of an organic acid amide.

12. The photocurable mixture as claimed in claim 11, wherein the units A-N₂X are derived from compounds of the general formula
(R¹-R²-)ₚR³-N₂X,
in which
X is the anion of the diazonium compound,
p is an integer from 1 to 3,
R¹ is an aromatic radical which is capable, in at least one position, of condensation with an active carbonyl compound,
R³ is a phenylene group,
R² is a single bond or one of the groups:
-(CH₂)_{q}-NR⁴-,
-O-(CH₂)ᵣ-NR⁴-,
-S-(CH₂)ᵣ-NR⁴-,
-S-CH₂CO-NR⁴-,
-O-R⁵-O-,
-O-,
-S-, or
-CO-NR⁴-,
where
q is a number from 0 to 5,
r is a number from 2 to 5,
R⁴ is a hydrogen atom, an alkyl group having from 1 to 5 carbon atoms, an aralkyl group having from 7 to 12 carbon atoms or an aryl group having from 6 to 12 carbon atoms, and
R⁵ is an arylene group having from 6 to 12 carbon atoms.

13. The photocurable mixture as claimed in claim 1, wherein the organic azido compound includes at least two azido groups in its molecule.

14. A photocurable recording material comprising a layer support and a photosensitive layer, wherein the photosensitive layer comprises a mixture as claimed in claim 1.

## Revendications

1. Composition photodurcissable qui contient un polycondensat d'un sel de diazonium ou un composé azido organique, comme composé photosensible, et, comme liant, un haut polymère qui comporte des motifs alcool vinylique, caractérisée en ce que le polymère est un copolymère greffé, comprenant un polyuréthane, comme support de greffe, sur lequel sont greffées des chaînes à motifs alcool vinylique.

2. Composition photodurcissable selon la revendication 1, caractérisée en ce que les chaînes greffées contiennent en outre des motifs ester vinylique.

3. Composition photodurcissable selon la revendication 1 ou 2, caractérisée en ce que les chaînes greffées contiennent en outre des motifs vinylacétal.

4. Composition photodurcissable selon la revendication 3, caractérisée en ce que les motifs vinylacétal dérivent d'un aldéhyde aliphatique ou cycloaliphatique.

5. Composition photodurcissable selon une quelconque des revendications 1 a 4, caractérisée en ce que les chaînes greffées contiennent en outre des motifs d'autres monomères à insaturation éthylénique, copolymérisables avec des esters vinyliques.

6. Composition photodurcissable selon la revendication 1, caractérisée en ce que le polyuréthane est un produit de polyaddition de diisocyanates avec des diols.

7. Composition photodurcissable selon la revendication 6, caractérisée en ce qu'on utilise, comme diol, un diol aliphatique en C₂₋₁₂, un diol cycloaliphatique en C₅₋₁₀ ou un polydiol aliphatique de masse moléculaire 200 à 100.000.

8. Composition photodurcissable selon la revendication 7, caractérisée en ce qu'on utilise, comme diol, un mélange de 1 mole de polydiol et de 0,1 à 0,7 mole de diol aliphatique de faible masse moléculaire.

9. Composition photodurcissable selon la revendication 6, caractérisée en ce qu'on utilise, comme diisocyanate, un diisocyanate aliphatique en C₄₋₁₅ ou un diisocyanate cycloaliphatique en C₇₋₁₅.

10. Composition photodurcissable selon la revendication 1 ou 6, caractérisée en ce que le polyuréthane possède une masse moléculaire de 200 à 100.000.

11. Composition photodurcissable selon la revendication 1, caractérisée en ce que le polycondensat de sel de diazonium est constitué de motifs récurrents A-N₂X et B, liés entre eux par des chaînons intermédiaires, de préférence des groupes méthylène, qui dérivent de composés carbonylés condensables, A étant le résidu d'un composé de diazonium aromatique condensable avec du formaldéhyde et B étant le résidu d'un composé condensable avec du formaldéhyde et dépourvu de groupes diazonium, en particulier d'une amine aromatique, d'un phénol, d'un éther de phénol, d'un thioéther aromatique, d'un hydrocarbure aromatique, d'un composé hétérocyclique aromatique ou d'un amide organique.

12. Composition photodurcissable selon la revendication 11, caractérisée en ce que les motifs A-N₂X dérivent de composés de formule générale
(R¹-R²-)ₚR³-N₂X ,
dans laquelle
- X représente l'anion du composé diazonium,
- p est un nombre entier de 1 à 3,
- R¹ représente un radical aromatique présentant au moins une position apte à la condensation avec un composé carbonylé actif,
- R³ est un groupe phénylène,
- R² représente une liaison simple ou un des groupes:
-(CH₂)_{q}-NR⁴-,
-O-(CH₂)ᵣ-NH⁴-,
-S-(CH₂)ᵣ-NR⁴-,
-S-CH₂CO-NR⁴- ,
-O-R⁵-O-,
-O- ,
-S- ou
-CO-NR⁴- ,
formules dans lesquelles:
- q est un nombre de 0 à 5,
- r est un nombre de 2 à 5,
- R⁴ représente l'atome d'hydrogène, un groupe alkyle en C₁₋₅, un groupe aralkyle en C₇₋₁₂ ou un groupe aryle en C₆₋₁₂, et
- R₅ représente un groupe arylène en C₆₋₁₂.

13. Composition photodurcissable selon la revendication 1, caractérisée en ce que le composé azido organique contient au moins deux groupes azido dans la molécule.

14. Matériau d'enregistrement photodurcissable à base d'un substrat et d'une couche photosensible, caractérisé en ce que la couche photosensible est constituée d'une composition selon la revendication 1.
